# EUROPEAN PATENT SPECIFICATION

(11) **EP 2 105 517 B1**
(45) Date of publication and mention of the grant of the patent: **21.07.2010**
(21) Application number: 08170298.7
(22) Date of filing: 28.11.2008
(51) Int. Cl.: C23C 14/34, C23C 14/50, C23C 14/56

(54) **Lubricant Coating Apparatus for High Temperature Parts**
Schmiermittelbeschichtungsvorrichtung für Hochtemperaturteile
Appareil de revêtement de lubrifiant pour pièces à haute température

(30) Priority: 26.03.2008 KR 20080027893
(43) Date of publication of application: 30.09.2009
(73) Proprietor: Korea Plant Service & Engineering Co., Ltd., Gyeonggi-do 463-726 (KR)
(72) Inventor: Choi, Sang-Hoon, 448-756, Gyeonggi-do (KR); Kim, Dong-Il, 448-992, Gyeonggi-do (KR); Lee, Dong-Il, 463-745, Gyeonggi-do (KR)
(74) Representative: CBDL Patentanwälte

(56) References cited:
- EP-A- 0 668 369
- EP-A- 1 524 329
- EP-A- 1 717 338
- EP-A- 1 876 257
- WO-A-97/34315
- US-A- 4 197 336
- US-A- 4 290 877
- US-A1- 2002 066 669
- US-A1- 2006 096 851
- US-A1- 2006 096 857

## Description

### 1. Field of the Invention

The present invention relates to a lubricant coating apparatus for high temperature parts, which forms a lubricant layer on the surface of a high temperature part using a sputtering method so as to prevent the high temperature part used in a power plant or the like from being damaged due to abrasion or galling.

### 2. Description of the Related Art

A boiler tube or gas turbine of a thermoelectric power plant, a stud bolt of a nuclear reactor, and other parts are parts used at high temperatures. The high temperature parts may suffer from damage such as abrasion or galling caused by the high load and temperature of joints, the hard particles of contact surfaces, and the increase of stagnation time.

In order to mitigate damage resulting from the abrasion or galling, typically, the method of applying an anti-seize compound to a surface of a high temperature part has been used. The anti-seize compound is a copper-based paste of a high metal content and a high solid lubricant content. However, the application of the anti-seize compound does not perfectly prevent the damage to high temperature parts.

### SUMMARY OF THE INVENTION

Accordingly, the present invention has been made keeping in mind the above problems occurring in the prior art, and an object of the present invention is to provide a lubricant coating apparatus for high temperature parts, which is capable of effectively preventing damage to parts used under high temperature conditions such as those of a power plant, that is, preventing abrasion and galling.

In order to accomplish the above object, the present invention provides a lubricant coating apparatus for a high temperature part, including a chamber which has a setting unit for setting the high temperature part therein and a door for defining a sputtering space for the high temperature part, a rotary drive means for rotating and driving the high temperature part set in the setting unit, a vacuum pump for creating a vacuum in the sputtering space of the chamber, an inert gas supply unit for providing an inert gas state to the sputtering space of the chamber, a plurality of targets which are mounted to the upper, front and back surfaces of the door in such a way as to face the high temperature part, a plurality of sputter guns which are mounted to the upper, front and back surfaces of the door in such a way as to correspond to the targets, release atoms from the targets and deposit the atoms onto the high temperature part, and a control unit for controlling the rotary drive means, the vacuum pump, the inert gas supply unit and the sputter gun.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a perspective view illustrating the appearance of a lubricant coating apparatus according to the preferred embodiment of the present invention;
FIG. 2 is a perspective view illustrating the state in which a door of the lubricant coating apparatus of FIG. 1 is opened;
FIG. 3 is a perspective view illustrating the state in which high temperature parts are set in the lubricant coating apparatus of FIG. 2;
FIG. 4 is a plan view illustrating a setting unit and a rotary drive means for large-sized parts installed in the lubricant coating apparatus of FIG. 2;
FIG. 5 is a perspective view illustrating a setting unit and a rotary drive means for small-sized parts installed in the lubricant coating apparatus of FIG. 2;
FIG. 6 is a perspective view illustrating a hoist for feeding high temperature parts into the lubricant coating apparatus of FIG. 1;
FIG. 7a is a view illustrating the state in which the high temperature parts are raised by the hoist of FIG. 6;
FIG. 7b is an enlarged view illustrating handling clamps provided on the hoist of FIG. 6; and
FIG. 8 is a view illustrating the state in which the high temperature parts are set in the lubricant coating apparatus by the hoist of FIG. 6.

### DESCRIPTION OF THE PREFERRED EMBODIMENTS

Hereinafter, the preferred embodiment of the present invention will be described in detail with reference to the accompanying drawings. It should be understood that the following embodiment is illustrative and not restrictive and intends to make those skilled in the art fully understand the invention, and that various changes and modifications may be made.

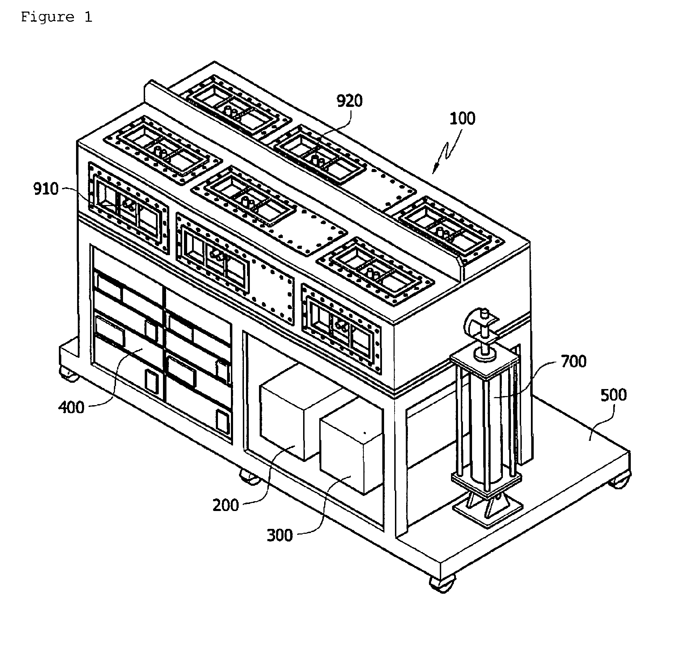

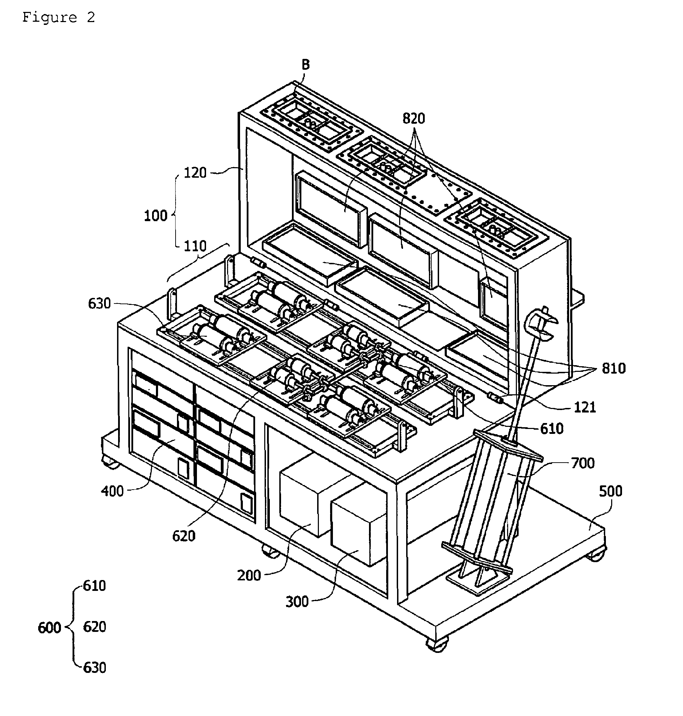

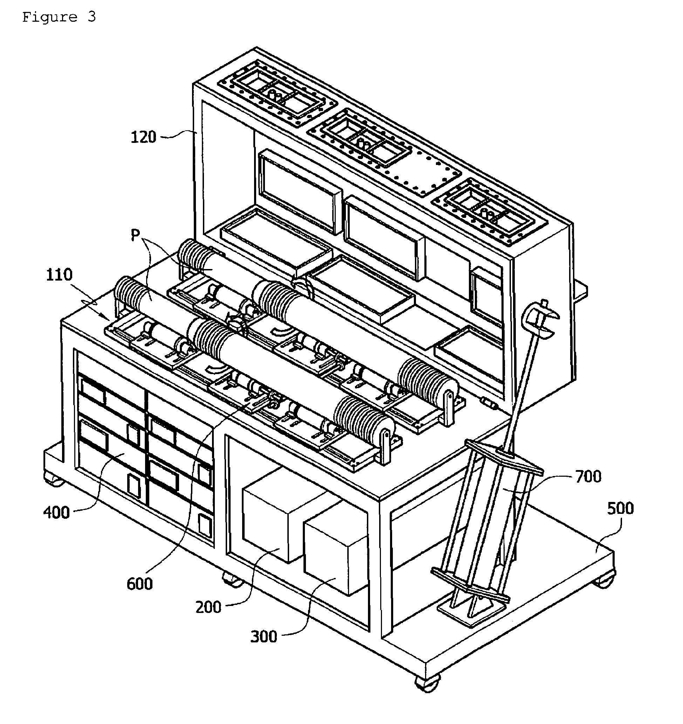

FIG. 1 is a perspective view illustrating the appearance of a lubricant coating apparatus according to the preferred embodiment of the present invention, FIG. 2 is a perspective view illustrating the state in which a door of the lubricant coating apparatus of FIG. 1 is opened, and FIG. 3 is a perspective view illustrating the state in which high temperature parts are set in the lubricant coating apparatus of FIG. 2.

As shown in FIGS. 1 to 3, the lubricant coating apparatus for high temperature parts according to the preferred embodiment of the present invention includes a chamber 100, a vacuum pump 200, an inert gas supply unit 300, and a control unit 400 which are mounted on a platform 500. A sputtering process for the high temperature parts P is performed in the chamber 100. The vacuum pump 200 creates a vacuum in the sputtering space of the chamber 100. The inert gas supply unit 300 creates an inert gas mode in the sputtering space of the chamber 100. The control unit 400 controls the sputtering process in the chamber 100.

Among these components, the chamber 100 in which the sputtering process is conducted includes a setting unit 110 in which high temperature parts P to be lubricated and coated by sputtering are set, and a door 120 which define the sputtering space for the high temperature parts P set in the setting unit 110. Further, a rotary drive means 600 is installed in the chamber 100, and rotates and drives the high temperature parts P so that the surface of each high temperature part P which is set in the setting unit 110 is evenly lubricated and coated.

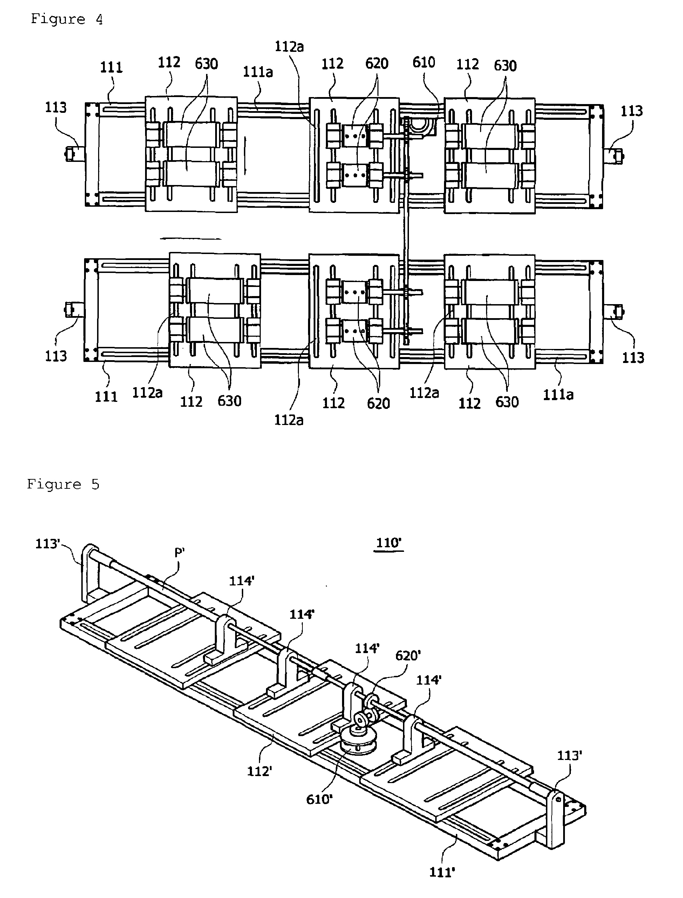

The detailed construction of the setting unit 110 is illustrated in FIG. 4. As shown in the drawing, the setting unit 110 includes frames 111, moving panels 112 and jigs 113. Each frame 111 is arranged to be long in the longitudinal direction of the high temperature part P. The moving panels 112 are mounted on each frame 111, and the jigs 113 are mounted to the left and right ends of each frame 111. According to the present invention, a plurality of moving panels 112 is provided on each frame 111. For example, three moving panels 112 are shown in the drawing. The rotary drive means 600 is installed to the moving panels 112. Particularly, left and right slide rails 111 a are provided on the frame 111 such that the moving panels 112 slide leftwards and rightwards on the frame 111. Further, front and rear slide rails 112a are provided on each moving panel 112 such that the rotary drive means 600 slides forwards and backwards. Further, the jigs 113 function to rotatably support both ends of the high temperature part P. As such, since the moving panels 112 may move leftwards and rightwards on the frame 111, and the rotary drive means 600 may move forwards and backwards on the moving panels 112, the high temperature part P can be stably supported and rotated by adjusting the arrangement of the rotary drive means 600 depending on the size and shape of the high temperature part P supported by the jigs 113.

According to this embodiment, the rotary drive means 600 includes a drive motor 610, drive rollers 620 and guide rollers 630. The rotating drive force generated by the drive motor 610 rotates and drives the drive rollers 620, thus rotating each high temperature part P. The guide rollers 630 function to stably support each high temperature part P when it is rotated. As shown in FIG. 4, a pair of drive rollers 620 is installed at the moving panel 112 which is provided on the central portion of each frame 111, and a pair of guide rollers 630 is installed at each of the left and right moving panels 112 which are provided on the left and right sides of each frame 111.

The setting unit 110 illustrated in FIG. 4 has a structure which is suitable for a large-sized part such as a stud bolt of a nuclear reactor. Meanwhile, a setting unit 110' illustrated in FIG. 5 may be applied to a small-sized part such as a manway stud bolt of a steam generator. That is, the setting unit 110' of FIG. 5 has props 114' which are provided on moving panels 112' mounted on a frame 111' to support a small-sized high temperature part P'. Drive rollers 620' for rotating the small-sized high temperature part P' which is supported by the props 114' and jigs 113' provided on the opposite ends of the frame 111' are installed together with a drive motor 610'. Since each of the setting units 110 and 110' illustrated in FIGS. 4 and 5 is fastened to the chamber 10 using a general fastening means such as a bolt, a suitable setting unit may be selected and installed in the chamber 100 according to the size and shape of a high temperature part.

As shown in FIGS. 1 to 3, the door 120 of the chamber 100 has the shape of a cuboid and closes the upper portion of the setting unit 110, thus forming the sputtering space. The door 120 rotates about tilting hinges 121 to be opened or closed. The operation of opening or closing the door 120 is conducted by general hydraulic and pneumatic mechanisms 700 such as hydraulic cylinders installed at the left and right ends of the platform 500. The operations of the hydraulic and pneumatic mechanisms 700 which include opening or closing the door 120 or controlling the opening angle are controlled by the control unit 400.

A plurality of targets 810 and 820 and a plurality of sputter guns 910 and 920 are mounted to the upper, front and back surfaces of the door 120 to perform a sputtering operation towards each high temperature part P set in the setting unit 110. That is, as shown in FIGS. 1 and 2, six targets 820 are placed in two rows on the upper surface in the door 120, and three targets 810 are placed on each of the front and back surfaces in the door 120. Each of the targets 810 and 820 is fastened to the door 120 by fastening means such as bolts B. Among the targets 810 and 820, the targets located at the centers of the upper, front and back surfaces may change their positions according to the length of each high temperature part P. That is, after the bolts B are removed, the frame of each central target is rotated at 180 degrees. In such a state, the adjusted target is fastened to the door 120 using the bolts B again. The sputter guns 910 and 920 are provided on the upper, front and back surfaces of the door 120 to correspond to the positions and numbers of the targets 810 and 820, release atoms from the targets 810 and 820 and deposit the atoms to the high temperature parts P.

The targets 810 and 820 are divided into adhesive-layer targets 810 and lubricant-layer targets 820. Particularly, the material of the lubricant-layer targets 820 has a low adhesive force, so that it is difficult to directly attach a lubricant-layer to the surface of each high temperature part P. Thus, in order to overcome the problem, the adhesive-layer targets 810 are provided to form a thin adhesive layer on the surface of the high temperature part P. The adhesive-layer targets 810 are made of nickel (Ni) having superior adhesive force, while the lubricant-layer targets 820 are made of silver-palladium (AgPd) alloy having a low frictional coefficient. In the sputtering of the high temperature parts P, the lubricant layer is formed subsequent to the adhesive layer. When the adhesive layer is formed under the control of the control unit 400, the application of power to the sputter guns 920 for the lubricant-layer targets 820 is stopped. In contrast, when the lubricant layer is formed, the application of power to the sputter guns 910 for the adhesive-layer targets 810 is stopped.

Meanwhile, the vacuum pump 200 may comprise a rotary pump or a turbo pump, and evacuate up to 1 X 10⁻⁶ torr, thus maintaining a vacuum in the sputtering space of the chamber 100. Further, the inert gas supply unit 300 supplies an inert gas having the purity of 99.999%, for example, argon (Ar), krypton (Kr) or xenon (Xe) to the chamber 100 in which the vacuum is created. A glow discharge is formed by the inert gas, and cations impact the cathode-biased targets 810 and 820, so that the atoms of the targets 810 and 820 deposit on the surface of each high temperature part P.

The operation of the rotary drive means 600, the vacuum pump 200, the inert gas supply unit 300 and the sputter guns 910 and 920 which are constructed as described above is controlled by the control unit 400 when the high temperature parts P are being lubricated and coated. The sputtering process performed by the lubricant coating apparatus of this embodiment will be described below.

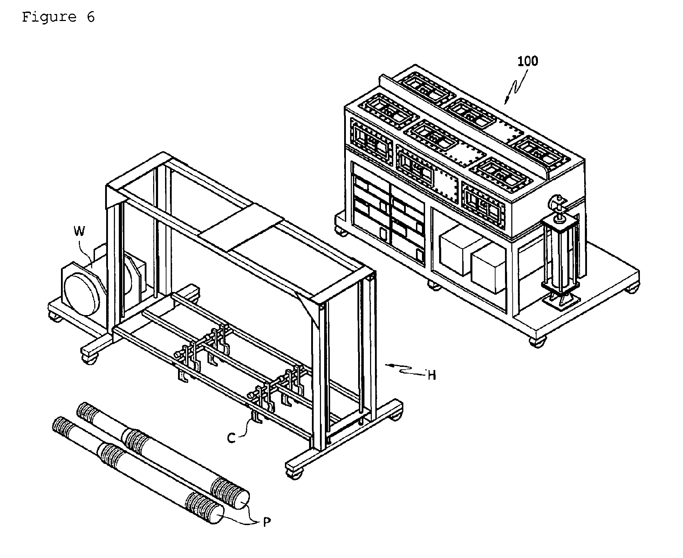

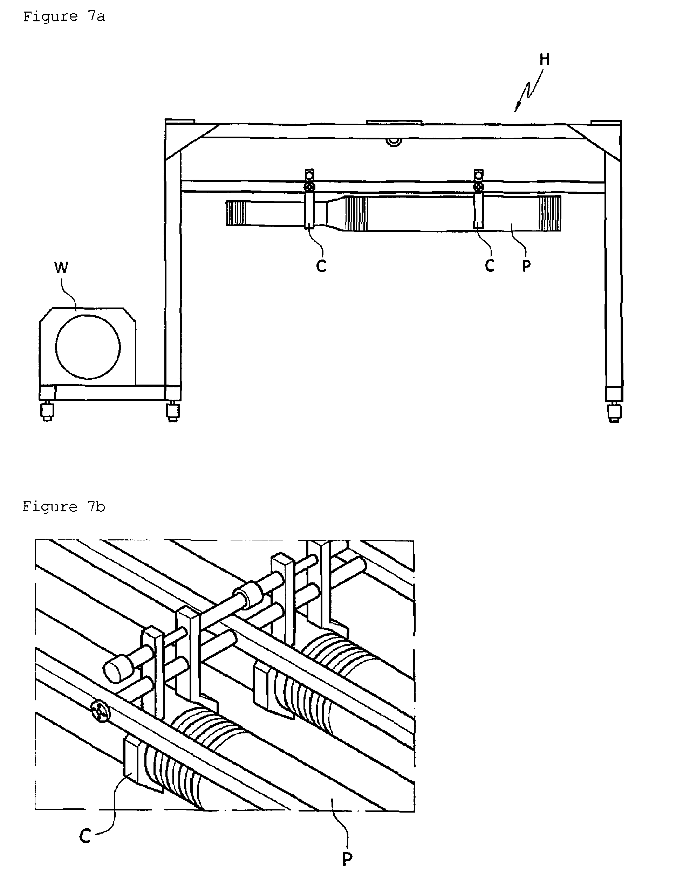

First, as shown in FIGS. 6 and 7a, according to the present invention, a hoist H is prepared to feed and load the high temperature parts P to be sputtered to the lubricant coating apparatus constructed as described above. Further, in order to remove oil or dust from the surface of each high temperature part P and appropriately form the adhesive layer on the surface of each high temperature part P through sputtering, the high temperature parts P are pre-treated to have the root mean square (RMS) roughness of about 600nm.

The hoist H is provided with clamps C to simultaneously grasp and load a plurality of high temperature parts P which are to be set in the setting unit 110. FIG. 7B illustrates general handling clamps which are manually manipulated by workers to clamp the high temperature parts P. The high temperature parts P held by the clamps C are lifted to a predetermined height by a winch W which is provided on the hoist H, and are fed into the chamber 100 of the lubricant coating apparatus.

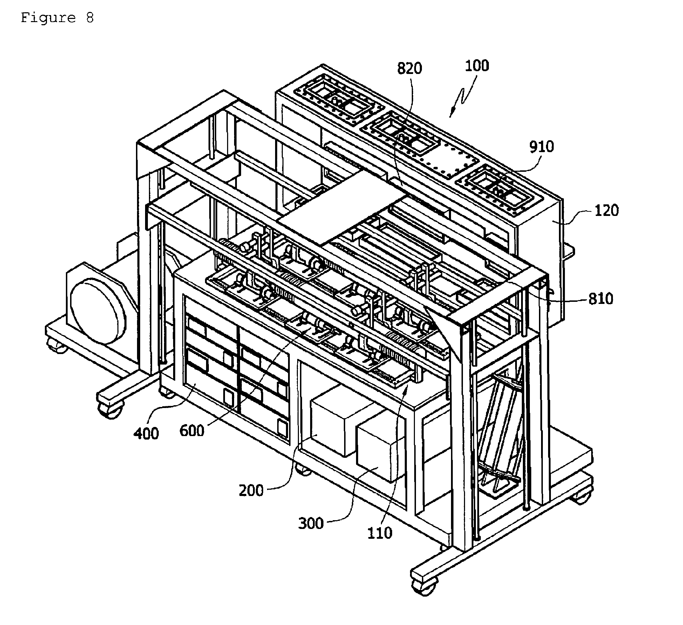

Subsequently, when the door 120 of the chamber 100 is opened as shown in FIG. 8, the high temperature parts P are loaded on the rotary drive means 600 placed on the setting unit 110. Next, the door 120 is closed. In such a state, the vacuum pump 200 is actuated under the control of the control unit 400, thus exhausting all air from the sputtering space of the chamber 100. The inert gas such as argon is supplied from the inert gas supply unit 300 to the sputtering space, thus creating an environment for performing the sputtering operation.

In the state where the inert gas is supplied to the chamber 100, the sputter guns 910 perform their operation for the adhesive-layer targets 810. At this time, the atoms are released from the adhesive-layer targets 810 and deposited on the surface of each high temperature part P, so that the adhesive layer is formed. At this time, the sputter guns 920 corresponding to the lubricant-layer targets 820 are controlled such that they are not operated. Thus, only atoms of the adhesive-layer targets 810 are released.

When the formation of the adhesive layer is completed by the adhesive-layer targets 810, the sputter guns 910 for the adhesive-layer targets 810 stop operating, and the sputter guns 920 for the lubricant-layer targets 820 starts operating. Thereby, the atoms of the lubricant-layer targets 820 are released, so that the lubricant layer is formed on the surface of each high temperature part P.

As such, when the adhesive and lubricating deposit layer is formed, among the atoms which are released from the targets 810 and 820 and are moved freely in the chamber 100, the atoms incident on each high temperature part form the deposit layer. Particularly, the sputtered atoms have relatively high kinetic energy by the transfer of momentum. Thus, when the deposit layer is formed on the surface of each high temperature part, the surface spreading of the atoms to a thermodynamically stable position is conducted, so that a compact structure is obtained. The thickness of the adhesive layer or lubricant layer formed in this way may be adjusted by controlling the time given to depositing.

Meanwhile, as shown in FIG. 3, since each high temperature part P is rotated by the rotary drive means 600, the adhesive layer and the lubricant layer are evenly deposited on the surface of the high temperature part P.

Generally, when two surfaces of metallic parts contacting each other are made of metallic materials having the same properties, they tend to adhere to each other at high temperature and pressure. However, according to the present invention, the lubricant layer formed on the surface of each high temperature part P completely prevents the part P from being in direct contact with another part having the same properties, so that adhesion between the parts is prevented.

When the adhesive layer and the lubricant layer have been deposited on the surface of each high temperature part P, the high temperature part P is clamped again by the hoist H and fed to a desired place.

As described above, the present invention provides a lubricant coating apparatus for high temperature parts, which forms a lubricant layer having chemical elements and mechanical properties different from those of a high temperature part on the surface of the high temperature part contacting another part, thus preventing the damage to the high temperature part, such as abrasion or galling. Therefore, the present invention reduces the repairing and restoring costs of the high temperature part, increases the life-span of the high temperature part and improves the reliability of equipment.

Further, the present invention provides a lubricant coating apparatus for high temperature parts which can be applied to a high temperature part installed in a nuclear power plant, thus eliminating the difficulties of working in a high radiation zone, and dramatically reducing the possibility of radiation exposure.

Although the preferred embodiment of the present invention has been disclosed for illustrative purposes, those skilled in the art will appreciate that various modifications, additions and substitutions are possible, without departing from the scope and spirit of the invention as disclosed in the accompanying claims.

## Claims

1. A lubricant coating apparatus for a high temperature part, comprising:
- a chamber having a setting unit for setting the high temperature part therein, and a door for defining a sputtering space for the high temperature part;
- rotary drive means for rotating and driving the high temperature part set in the setting unit;
- a vacuum pump for creating a vacuum in the sputtering space of the chamber;
- an inert gas supply unit for providing an inert gas state to the sputtering space of the chamber;
- a plurality of targets mounted to upper, front and back surfaces of the door in such a way as to face the high temperature part;
- a plurality of sputter guns mounted to upper, front and back surfaces of the door in such a way as to correspond to the targets, releasing atoms from the targets and depositing the atoms onto the high temperature part; and
- a control unit for controlling the rotary drive means, the vacuum pump, the inert gas supply unit and the sputter gun.

2. The lubricant coating apparatus as set forth in claim 1, wherein the setting unit comprises:
- a moving panel having front and rear slide rails to slide the rotary drive means forwards and backwards;
- a frame having left and right slide rails to slide the moving panel leftwards and rightwards; and
- a jig provided on each of left and right ends of the frame to rotatably support the high temperature part.

3. The lubricant coating apparatus as set forth in claim 1 or 2, wherein the setting unit is replaceable according to a size and a shape of the high temperature part.

4. The lubricant coating apparatus as set forth in claim 1, further comprising: a hydraulic and pneumatic mechanism operated under control of the control unit and rotating the door to open or close the door.

5. The lubricant coating apparatus as set forth in claim 1, wherein the rotary drive means comprises:
- a drive motor for generating a rotating drive force;
- a drive roller provided at a center of the frame and rotated by the drive motor; and
- a guide roller located at each of left and right sides of the drive roller.

6. The lubricant coating apparatus as set forth in claim 1, wherein each of the targets is fastened to the door via a bolt such that a predetermined target changes a position thereof in an axial direction of the high temperature part.

7. The lubricant coating apparatus as set forth in claim 1, wherein some of the targets are adhesive-layer targets, and the remaining targets are lubricant-layer targets.

8. The lubricant coating apparatus as set forth in claim 7, wherein each of the adhesive-layer targets is made of nickel and each of the lubricant-layer targets is made of silver-palladium alloy.

## Patentansprüche

1. Schmiermittelbeschichtungsvorrichtung für ein Hochtemperaturteil, umfassend:
- eine Kammer mit einer Platzierungseinheit, um das Hochtemperaturteil darin zu plazieren, und einer Tür, um einen Sputterraum für das Hochtemperaturteil zu definieren,
- Drehantriebsmittel, um das in der Platzierungseinheit plazierte Hochtemperaturteil zu drehen und anzutreiben,
- eine Vakuumpumpe, um in dem Sputterraum der Kammer einen Unterdruck zu erzeugen,
- eine Inertgaszuführeinheit, um eine Inertgasphase dem Sputterraum der Kammer zuzuführen,
- eine Mehrzahl von Targets, die an oberen, vorderen und rückwärtigen Oberflächen der Tür derart angebracht sind, daß sie dem Hochtemperaturteil zugewandt sind,
- mehrere Sputterkanonen, die an oberen, vorderen und rückwärtigen Oberflächen der Tür derart angeordnet sind, daß sie mit den Targets korrespondieren, Atome aus den Targets lösen und die Atome auf dem Hochtemperaturteil ablagern, und
- eine Steuereinheit zum Steuern der Drehantriebsmittel, der Vakuumpumpe, der Inertgaszuführeinheit und der Sputterkanonen.

2. Schmiermittelbeschichtungsvorrichtung gemäß Anspruch 1, wobei die Plazierungseinheit umfaßt:
- eine Bewegungsplatte mit vorderen und rückwärtigen Gleitschienen, um die Drehantriebsmittel vorwärts und rückwärts zu verschieben,
- einen Rahmen mit linken und rechten Gleitschienen, um die Bewegungsplatte nach links und nach rechts zu verschieben, und
- Lager, die an jedem der linken und rechten Enden des Rahmens vorgesehen sind, um das Hochtemperaturteil drehbar zu lagern.

3. Schmiermittelbeschichtungsvorrichtung gemäß Anspruch 1 oder 2, wobei die Plazierungseinheit gemäß einer Größe und einer Form des Hochtemperaturteils austauschbar ist.

4. Schmiermittelbeschichtungsvorrichtung nach Anspruch 1, ferner umfassend:
einen Hydraulik- und Pneumatikmechanismus, der unter Steuerung durch die Steuereinheit betrieben wird und die Tür dreht, um die Tür zu öffnen oder zu schließen.

5. Schmiermittelbeschichtungsvorrichtung nach Anspruch 1, wobei die Drehantriebsmittel umfassen:
- einen Antriebsmotor zum Erzeugen einer Drehantriebskraft,
- eine Antriebsrolle, die in einem Zentrum des Rahmens vorgesehen ist und von dem Antriebsmotor gedreht wird, und
- jeweils eine an der linken und der rechten Seite der Antriebsrolle angeordnete Führungsrolle.

6. Schmiermittelbeschichtungsvorrichtung nach Anspruch 1, wobei jedes der Targets mittels eines Bolzens an der Tür derart befestigt ist, daß ein vorbestimmtes Target seine Position in einer axialen Richtung des Hochtemperaturteils ändert.

7. Schmiermittelbeschichtungsvorrichtung nach Anspruch 1, wobei einige der Targets Haftschichttargets sind und die anderen Targets Schmiermittelschichttargets sind.

8. Schmiermittelbeschichtungsvorrichtung nach Anspruch 7, wobei jedes der Haftschichttargets aus Nickel hergestellt ist und jedes der Schmiermittelschichttargets aus einer Silber-Palladium-Legierung hergestellt ist.

## Revendications

1. Dispositif de revêtement de lubrifiant pour une pièce à haute température, comprenant:
- une chambre ayant une unité de mise en place pour y mettre en place ladite pièce à haute température, ainsi qu'une porte afin de définir un espace de pulvérisation cathodique pour la pièce à haute température,
- des moyens d'entraînement en rotation pour faire tourner et entraîner la pièce à haute température qui est mise en place dans ladite unité de mise en place,
- une pompe à vide afin de créer une dépression dans ledit espace de pulvérisation cathodique de la chambre,
- une unité d'admission de gaz inerte pour admettre une phase de gaz inerte à l'espace de pulvérisation cathodique de la chambre,
- une pluralité de cibles montées sur des surfaces supérieures, avant et arrière de la porte de manière à être tournées vers ladite pièce à haute température,
- une pluralité de canons de pulvérisation cathodique qui sont disposés sur des surfaces supérieures, avant et arrière de la porte de manière à correspondre aux cibles, détachent des atomes desdites cibles et déposent les atomes sur ladite pièce à haute température, et
- une unité de commande pour commander lesdits moyens d'entraînement en rotation, ladite pompe à vide, ladite unité d'admission de gaz inerte et les canons de pulvérisation cathodique.

2. Dispositif de revêtement de lubrifiant selon la revendication 1, dans lequel ladite unité de mise en place comprend :
- un panneau de mouvement ayant des glissières avant et arrière pour déplacer en avant et en arrière lesdits moyens d'entraînement en rotation,
- un bâti présentant des glissières gauches et droites pour déplacer à gauche et à droite ledit panneau de mouvement, et
- des supports prévus à chacune des extrémités gauche et droite du bâti afin de loger à rotation ladite pièce à haute température.

3. Dispositif de revêtement de lubrifiant selon la revendication 1 ou 2, dans lequel ladite unité de mise en place est remplaçable selon une taille et une forme de la pièce à haute température.

4. Dispositif de revêtement de lubrifiant selon la revendication 1, comprenant en outre : un mécanisme hydraulique et pneumatique qui est actionné sous la commande de ladite unité de commande et fait tourner ladite porte afin d'ouvrir ou de fermer la porte.

5. Dispositif de revêtement de lubrifiant selon la revendication 1, dans lequel les moyens d'entraînement en rotation comprennent :
- un moteur de commande destiné à générer une force motrice de rotation,
- un rouleau moteur qui est prévu à un centre du bâti et est tourné par ledit moteur de commande, et
- un rouleau de guidage disposé respectivement sur le côté gauche et sur le côté droit du rouleau moteur.

6. Dispositif de revêtement de lubrifiant selon la revendication 1, dans lequel chacune des cibles est fixée sur la porte au moyen d'un boulon de telle manière qu'une cible prédéterminée change sa position dans une direction axiale de la pièce à haute température.

7. Dispositif de revêtement de lubrifiant selon la revendication 1, dans lequel quelques-unes des cibles sont des cibles à couche adhésive et les cibles restantes sont des cibles à couche de lubrifiant.

8. Dispositif de revêtement de lubrifiant selon la revendication 7, dans lequel chacune des cibles à couche adhésive est réalisée en nickel et chacune des cibles à couche de lubrifiant est réalisée à partir d'un alliage argent-palladium.
